# EUROPÄISCHE PATENTSCHRIFT

(11) **EP 0 867 517 B1**
(45) Veröffentlichungstag und Bekanntmachung des Hinweises auf die Patenterteilung: **28.06.2000**
(21) Anmeldenummer: 98101659.5
(22) Anmeldetag: 31.01.1998
(51) Int. Cl.: C22C 47/12, C22C 49/14

(54) **Aluminiummatrix-Verbundwerkstoff und Verfahren zu seiner Herstellung**
Composite with an aluminium matrix and a method for its production
Composite à matrice en alliage d'aluminium et procédé de fabrication

(30) Priorität: 26.03.1997 DE 19712624
(43) Veröffentlichungstag der Anmeldung: 30.09.1998
(73) Patentinhaber: VAW aluminium AG, 53117 Bonn (DE)
(72) Erfinder: Feikus, Franz Josef, Dr., 53123 Bonn (DE); Sach, Achim, Dipl.-Ing., 53757 St. Augustin (DE)
(74) Vertreter: Müller-Wolff, Thomas, Dipl.-Ing.

(56) Entgegenhaltungen:
- DELANNEY, F, ET AL.: "Processing, properties of low melting point metal matrix composites reinforced with continuous ductile fibres" WOODHEAD PUBLISHING LTD., CONFERENCE: TENTH INTERNATIONAL CONFERENCE ON COMPOSITE MATERIALS. II. METAL MATRIX COMPOSITES, WHISTLER, , 14. - 18.August 1995, CANADA, Seiten 605-612, XP002072366
- LEHNERT, F. ET AL.: "Production, properties and applications of metallic short fibres" MATERIALWISSENSCHAFT UND WERKSTOFFTECHNIK, Bd. 22, Nr. 9, September 1991, GERMANY, Seiten 355-358, XP002072367
- HEYDER, B. ET AL.: "Fabrication of metallic reinforcement fibres for metal matrix composites by in-rotating-liquid spinning" METALL, Bd. 46, Nr. 2, Februar 1992, GERMANY, Seiten 134-138, XP002072368
- PATENT ABSTRACTS OF JAPAN vol. 010, no. 373 (C-391), 12.Dezember 1986 & JP 61 166935 A (MAZDA MOTOR CORP), 28.Juli 1986,
- PATENT ABSTRACTS OF JAPAN vol. 014, no. 047 (C-0682), 29.Januar 1990 & JP 01 279720 A (TOYOTA MOTOR CORP), 10.November 1989,
- PATENT ABSTRACTS OF JAPAN vol. 011, no. 267 (C-443), 28.August 1987 & JP 62 067132 A (NIPPON KOKAN KK), 26.März 1987,

## Beschreibung

Die Erfindung betrifft einen Aluminiummatrix-Verbundwerkstoff bestehend aus einem in einer Aluminiumlegierung eingelagerten porösen Faservorkörper mit einer im Vergleich zur Aluminiummatrix höheren Festigkeit und einem verbesserten Verschleißverhalten sowie ein Verfahren zu seiner Herstellung.

Derartige Aluminiummatrix-Verbundwerkstoffe werden beispielsweise als Einzylinder- bzw. Mehrzylinderblock aus einer Aluminiumlegierung hergestellt, wobei in den Zylinder ein die Zylinderlaufbahn bildender, mit einer untereutektischen Aluminiumlegierung penetrierter hohlzylinderförmiger Formkörper aus keramischen Fasern mit darin eingefügten Siliziumkörpern eingegossen ist. Durch diese Maßnahme sollen die tribologischen Eigenschaften der Zylinderlauffläche verbessert werden.

Ein Problem bei der mechanischen Beaufschlagung derartiger Verbundwerkstoffe besteht darin, daß wegen des hohen Siliziumgehalts ein erhöhter Werkzeugverschleiß bei der mechanischen Bearbeitung des Zylinderblocks bzw. ein Kolbenverschleiß im Betriebsfalle auftritt. Dieser Nachteil kann dadurch vermindert werden, daß der Faseranteil und der Anteil an Siliziumkörnern so groß bemessen wird, daß ein großflächiger Kontakt zwischen der Aluminiumlegierungsmatrix des Zylinders und dem Werkzeug bzw. dem Kolben nicht entsteht. Dennoch muß aber der Kolbenschaft mit einer Eisenschicht versehen werden, damit der Verschleiß des Kolbenschaftes in erträglichen Grenzen gehalten werden kann.

Ein weiteres Problem der bekannten Faserverbundwerkstoffe besteht darin, daß eine Wiederverwendung der Rohstoffe nur durch aufwendige Recyclingverfahren mit zusätzlicher Trennstufe für die Fasern möglich ist. Hierbei können die metallischen von den nicht-metallischen Materialien nicht vollständig getrennt werden und müssen daher nachfolgend gesondert aufgearbeitet werden.

Es ist weiterhin bekannt, daß das Benetzungsverhalten von keramischen Fasern durch Metallschmelzen sehr ungünstig ist. Deshalb wurde es bisher als erforderlich angesehen, die Aluminiumlegierungsschmelze unter hohem Druck von bis zu 3000 bar bis zur Erstarrung einwirken zu lassen. Hierdurch wird der Verfahrensablauf bei der Herstellung von Aluminiummatrix-Verbundwerkstoffen deutlich verteuert.

Gleiches gilt für die aus sprühkompaktiertem Material hergestellten Verstärkungselemente, die gemäß EP 0 271 222 A2 aus mehreren Schichten von Feuerfestmaterial bestehen können. Dabei besteht allerdings die Gefahr der Reaktion von Fasermaterial und Schmelze, so daß nur kurze Infiltrationszeiten angesetzt werden dürfen, damit keine Metallcarbide oder Metallnitride gebildet werden.

Delannay, F. et al., "Processing and properties of low melting point metal matrix composites reinforced with continuous ductible fibres", 1995, offenbart einen Aluminiummatrix-Verbundwerkstoff mit eingelagerten, porösen Faservorkörpern.

Aufgrund zahlreicher Untersuchungen wurde ferner festgestellt, daß - bedingt durch das unterschiedliche Temperaturverhalten von Keramik und Metallwerkstoffen - sehr ungünstige Toleranzbereiche bei den unterschiedlichen Betriebsbedingungen von Verbrennungskraftmaschinen auftreten können. Diese führen unter Extrembedingungen zur Riefenbildung zwischen Kolbenschaft und Zylinderlaufbahn oder - im anderen Extremfall - zu erhöhtem Ölverlust infolge auftretender Durchblaseffekte.

Aufgabe der vorliegenden Erfindung ist es, die tribologischen Eigenschaften von bekannten Aluminiummatrix-Verbundwerkstoffen, insbesondere in der Anwendung auf Zylinderlaufbuchsen für Motorblöcke, zu verbessern und das Toleranzfeld durch Anpassung der temperaturabhängigen Werkstoffeigenschaften einzuengen, wobei die Nachteile bekannter Aluminiummatrix-Verbundwerkstoffe durch Verbesserung des Benetzungsverhaltens während der Infiltration vermieden werden sollen.

Diese Aufgabe wird durch die in den Patentansprüchen angegebenen Merkmale gelöst.

Das Verschleißverhalten eines erfindungsgemäß hergestellten Aluminiummatrix-Verbundwerkstoffs kann wie folgt beeinflußt werden:
1. Es ist erstmalig möglich, eine Paarung von artgleichen (metallischen) Werkstoffen für die Reibpartner bei faserverstärkten Materialien herzustellen. Darin ist das temperaturabhängie Festigkeitsverhalten wesentlich verbessert.
2. Durch die Steuerung der Porengröße wird die Volumenverteilung der Matrix und des Faseranteils beeinflußt, so daß die Festigkeiten und Reibpaarungen lokal einstellbar sind.
3. Im Extremfall lassen sich die Reibflächen vollständig aus Fasermaterial und die Schichtflächen vollständig aus einer Metallmatrix herstellen.

Der vorgenannte Extremfall läßt sich durch folgendes Beispiel erläutern:

Im Anwendungsfall für eine Lauffläche bei einem Ein- oder Mehrzylindermotor kann der erfindungsgemäße Aluminiummatrix-Verbundwerkstoff mit besonders günstigen Eigenschaften hinsichtlich eines Spiel- und Toleranzausgleiches eingesetzt werden. Durch den artgleichen Werkstoff (Infiltrationswerkstoff) für Zylinder/Laufbüchsen und Kolbenmantelflächen sind sowohl beim Kaltstart eines Motors als auch im Dauerbetrieb, bei Beschleunigungs- und Vollgaszyklen keine Maßabweichungen zwischen den verwendeten Materialien feststellbar. Somit ist auch das Emissionsverhalten von mit dem erfindungsgemäßen Verfahren hergestellten Laufflächen bei Ein- und Mehrzylindermotoren über den gesamten Betriebsbereich wesentlich verbessert im Vergleich zu herkömmlich hergestellten Verbundwerkstoffen, die mit vollkeramischen Fasern verstärkt worden sind.

Als weiterer Vorteil ergibt sich aus dem günstigen Benetzungsverhalten während der Infiltration, da die metallischen und/oder intermetallischen Fasern durch eine Aluminiumgußlegierung besonders leicht, also auch drucklos benetzt werden. Dieses ist vornehmlich bei automatisierten Verarbeitungsverfahren, wie z.B. dem Druckgieß-Verfahren von großer Bedeutung, da die einzelnen Verfahrensschritte in relativ kurzer Zeit ablaufen können und dennoch eine vollflächige Benetzung der Fasern des Faservorkörpers sichergestellt ist. Eine gute Benetzung bedeutet hohe Formfüllung und damit eine gute Verankerung des Faservorkörpers in der Matrix, so daß der erfindungsgemäße Verbundwerkstoff eine mindestens doppelt so hohe Formstabilität aufweist, verglichen mit einem konventionell druckgegossenen Aluminiummatrixwerkstoff mit oxidkeramischer Faser.

Durch die verbesserte Formstabilität des Faservorkörpers sind andererseits auch hohe Fertigungsgeschwindigkeiten mit modernen Fertigungsverfahren möglich. Beispielsweise läßt sich die Schußfolge unter gleichzeitig zunehmenden Einpreßdruck im Druckgieß-verfahren erhöhen, so daß die Stückzahlen bei sinkender Ausschußrate um mehr als das dreifache über denen vergleichbarer Verbundmaterialien auf keramischer Basis liegen.

Der Faseranteil im erfindungsgemäßen Aluminiummatrix-Verbundwerkstoff kann dem jeweiligen Beanspruchungsfall angepaßt werden. Somit sind neue Verbundwerkstoffe mit Gradientenstruktur und spezifischen Festigkeits-Dehnungseigenschaften herstellbar. Dadurch verringert sich der Fertigungsaufwand, insbesondere bei kompliziert geformten Bauteilen.

Umfangreiche Bearbeitungen an der Arbeitsfläche mit den verbesserten rheologischen Eigenschaften können vermieden werden, wenn die Konstruktion des Teiles darauf abgestimmt ist. Es lassen sich mit dem erfindungsgemäßen Verfahren an einem Bauteil sowohl hochbeanspruchte Gleitflächen als auch temperaturbeanspruchte Dichtflächen, z.B. im Zylinderkopfbereich herstellen. Sogar Spannteile mit verbessertem Dehnungsverhalten sind in einem kostengünstigen Gesamtverfahren herstellbar.

Entscheidend ist dabei die Struktur, der Aufbau und die Zusammensetzung des Faservorkörpers, der eine offenporige, metallische Struktur im Porositätsbereich von 20-98 % mit Porengrößen von 1 µ - 3 mm aufweisen kann. Ferner kann die Oberflächenrauhigkeit der porösen Struktur variiert werden und damit das Infiltrationsvermögen der Schmelze in die porose Struktur beeinflußt werden. So ist es möglich, eine sehr gute mechanische Verankerung der Fasern durch eine rauhe Struktur zu erzielen, während bei einer glatten Oberfläche der Fasern die poröse Struktur besser infiltriert werden kann.

Da der erfindungsgemäße Aluminiummatrix-Verbundwerkstoff aus artgleichen Bestandteilen zusammengesetzt ist, weist er eine homogene Festigkeitsstruktur auf, die zu einem sehr guten Thermoschock-Verhalten führt. Da außerdem seine Wärmeleitfähigkeit entsprechend der metallischen Basis sehr hohe Werte erreicht, ist seine Anwendung im Motorenbereich von Verbrennungskraftmaschinen besonders interessant. Hinzu kommt eine gute spanende und spanlose Verarbeitbarkeit, insbesondere in der Übergangszone von reinen metallischen und Aluminiummatrix-Verbundwerkstoffen, die bisher zu Problemen durch unterschiedliche Werkstoffstrukturen führten.

Für die Verwendung von Zylinderlaufbuchsen aus Verbundwerkstoffen ist es erforderlich, daß der Ausdehnungskoeffizient der Faserformkörper dem Matrixmaterial bzw. der Grundlegierung weitestgehend angepaßt ist. Dies ist erstmalig mit dem erfindungsgemäßen Aluminiummatrix-Verbundwerkstoff möglich, denn der Faserformkörper aus einem metallischen und/oder einem intermetallischen Fasermaterial kann durch Veränderung seiner Zusammensetzung weitgehend an die metallische Umgebung angepaßt werden. Poröse Keramikstrukturen besitzen demgegenüber ein sehr eingeschränktes Eigenschaftsspektrum.

Für die Optimierung der Verschleißeigenschaften stehen die in den Ansprüchen aufgeführten Eisen- und Nickel-Basiswerkstoffe oder die Intermetallics, wie Eisen-, Nickel-, Titan-Aluminide, Wolfram, Kupfer, Kobalt, Magnesium zur Verfügung. Durch eine sinnvolle Kombination lassen sich je nach den Anforderungen spezielle Eigenschaften, wie geringe Dichte, gute Wärmeleitfähigkeit, gute Korrosionsbeständigkeit, gute mechanische Bearbeitbarkeit mit Vorteil kombinieren.

Zusätzlich zu der stofflichen Auswahl besteht die Möglichkeit bei dem erfindungsgemäßen Aluminiummatrix-Verbundwerkstoff eine Gradientenstruktur in dem Faservorkörper auszubilden. Dieser kann beispielsweise eine steigende oder fallende Porosität oder steigende oder fallenden Porengrößen über den Querschnitt gesehen aufweisen. Hiermit ist es möglich, die erforderlichen Eigenschaften im Metallmatrix-Faserverbund beanspruchungsgerecht zu gestalten.

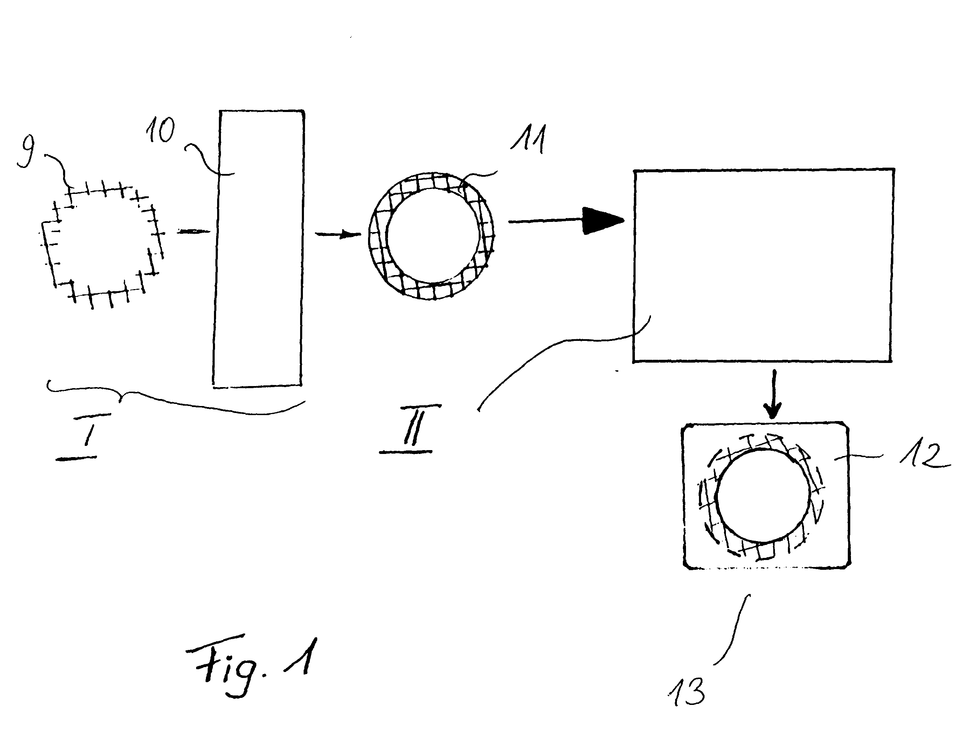

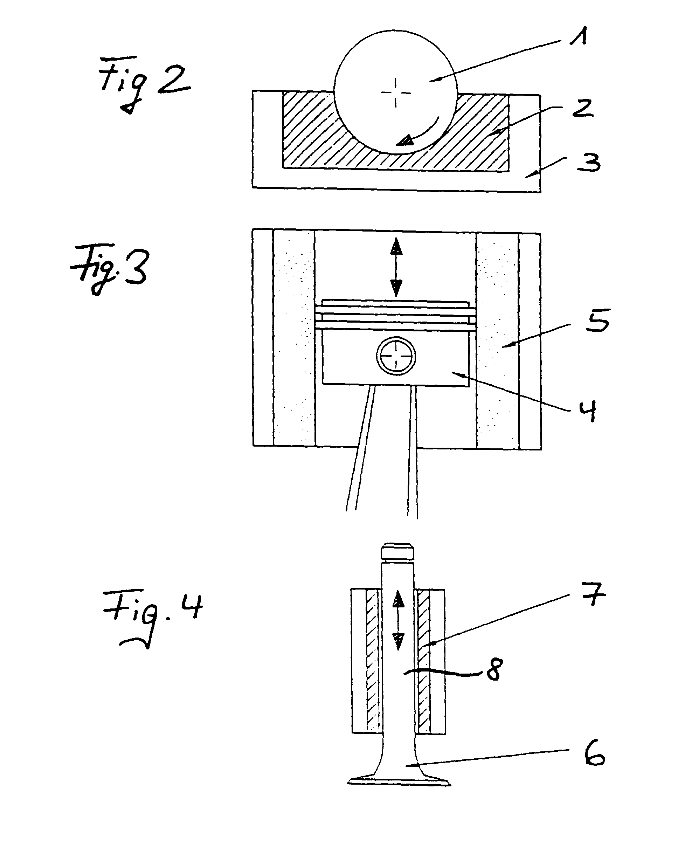

Im folgenden wird ein Herstellungsbeispiel (Fig. 1) sowie einige spezifische Anwendungsbeispiele gegeben, die den Erfindungsgedanken in bevorzugter Weise zur Geltung bringen und weitere nutzbringende Eigenschaften erkennen lassen. Dieses betrifft insbesondere die Anwendung als
Lagerwerkstoff gemäß Fig. 2,
Zylinderlauffläche (Fig. 3) und für einen
Ventilsitz gemäß Fig. 4.

Wie aus Figur 1, Verfahrensstufe I hervorgeht, wird zunächst ein Faserformkörper 9 durch Sintern in einem Ofen 10 zu einer festen Struktur verbunden. Nach dem Abkühlen des Formkörpers kann er zu einem Faservorkörper 11 ausgebildet werden.

In der Verfahrensstufe II wird der Faservorkörper 11 mit einer Aluminiumlegierung umgossen, die den Matrixwerkstoff 12 bildet. Es entsteht dann ein Aluminiummatrix-Verbundwerkstoff 13, der beispielsweise als Lagerwerkstoff, als Zylinderlauffläche oder Ventilführung eingesetzt werden kann.

Im Beispiel Lagerwerkstoff ist nach Fig. 2 vorgesehen, daß Welle 1 und Lagerschale 2 aus Aluminiumlegierungen, z.B. die Welle aus einer Al-Knetlegierung und die Lagerschale aus einer Al-Gußlegierung in Form eines infiltrierten Faservorkörpers bestehen, und dadurch mit artgleicher Werkstoffpaarung ausgestattet sind. Die äußere Abdeckung 3 kann aus reinem Matrixmetall hergestellt werden, z.B. aus gut schweißbarer AlMgSi- oder AlZnMg-Legierung.

Im Anwendungsfall einer Zylinderlauffläche kann die Werkstoffpaarung zwischen Kolben 4 und Inliner 5 gemäß Fig. 3 zu verbesserten Gleiteigenschaften führen. Beispielsweise besteht der Kolben 4 aus Aluminium und die Zylinderlauffläche (Inliner 5) aus einem infiltrierten Gradienten-Werkstoff auf Basis Aluminium. Ein Spielausgleich ist nicht erforderlich, da die äußere Schicht des infiltrierten Faservorkörper ein nahezu gleiches thermisches Ausdehnungsverhalten wie die Kolbenmantelfläche aufweist.

Im dritten in Fig. 4 dargestellten Anwendungsbeispiel ist der Ventilsitz und das Ventil 6 aus unterschiedlichen Werkstoffen hergestellt. Während der Ventilwerkstoff, beispielsweise Stahl, sehr gute Festigkeitseigenschaften bei hoher Temperaturfestigkeit aufweisen muß, ist die Ventilführung 7 aus einem infiltrierten Gradientenwerkstoff mit einer Aluminiummatrix-Legierung ausgebildet. Diese kann im Verschleißverhalten durch Gradientenstruktur dem Verschleißverhalten des Ventilschaftes 8 angepaßt werden.

Wie aus den vorstehenden Beispielen hervorgeht, lassen sich die motorspezifischen Laufeigenschaften und das motorspezifische Verschleißverhalten durch die Verwendung der angegebenen Werkstoffpaarungen erheblich verbessern. Es ist zu erwarten, daß die Laufleistungen durch das gleichbleibende Verschleißverhalten und die beständigen Toleranzabmessungen wesentlich verbessert werden.

Ferner läßt sich der Ölverbrauch und dadurch das Emissionsverhalten im Anwendungsbereich der erfindungsgemäßen Verbundwerkstoffe verbessern. Diese Erwartung knüpft sich an die Erkenntnis, daß die Tribologie der verwendeten Werkstoffe und das Emissionsverhalten eng miteinander verbunden sind. Die Ölhaftung wird durch die spezifische Oberfläche der erfindungsgemäßen Verbundwerkstoffe verbessert.

Das Abriebverhalten der erfindungsgemäßen Verbundwerkstoffe ist vergleichbar mit dem der Nickel-Calcium-Silikatschichten, die ein sehr günstiges Verschleißverhalten zeigen. Das Ausdehnungsverhalten kommt dem der keramischen Verbundwerkstoffe sehr nahe. Durch Verwendung von oxidationsbeständigen Legierungen ist die Infiltration des Faservorkörpers so günstig, daß bei einer vollständigen Benetzung der Verbundmaterialien gesprochen werden kann.

Für einen gezielten Aufbau der erfindungsgemäßen Verbundmaterialien lassen sich auch gerichtete Faserstrukturen erzeugen, die beispielsweise durch magnetische Orientierung der Fasern in vorgegebener räumlicher Struktur ausgerichtet werden können. Es lassen sich dadurch beliebige, nichtsymmetrische Faservorkörper herstellen, deren Einzelfasern in der beanspruchten Raumrichtung orientiert sind.

Trotz der Vielzahl von Anwendungsmöglichkeiten und der unterschiedlichen Legierungszusammensetzung im infiltrierten Faservorkörper und in der Matrix lassen sich die erfindungsgemäßen Verbundwerkstoffe problemlos recyclieren. Die bisher erforderlichen aufwendigen Reinigungsverfahren bzw. die Abtrennung nichtkeramischer Fasern sind nicht mehr erforderlich.

## Patentansprüche

1. Aluminiummatrix-Verbundwerkstoff, bestehend aus einem in eine Aluminiumlegierung eingelagerten, porösen Faservorkörper mit einer im Vergleich zur Aluminiummatrix höheren Festigkeit und einem verbesserten Verschleißverhalten, wobei
1.1 der Faserkörper aus Fasern einer oxidationsunempfindlichen Eisen-Chrom-Aluminiumlegierung mit Fe = 50 - 85 Gew.-%, Cr = 10 - 30 Gew.-%, Al = 5 - 20 Gew.-% oder aus Aluminium-Nickel-Legierungen mit Aluminiumgehalten von 7 - 40 % oder aus Eisen-Nickel-Aluminiumlegierungen oder aus intermetallischen Aluminiden vom Typ AlFe, AlTi, AlNi besteht,
1.2 die durch ein Schmelzextraktionsverfahren gewonnenen Fasern des Faservorkörpers aus Einzelfäden der Länge L = 0,5 bis 5 mm mit einem Faserdurchmesser von 1 bis 50 µm bestehen,
1.3 der Faservorkörper mit einer siliziumhaltigen Aluminiumgußlegierungsschmelze infiltriert ist, wobei der Si-Gehalt der Schmelze 5 bis 14 Gew.-% beträgt,
1.4 der Verbundwerkstoff mindestens eine Arbeitsfläche mit einem verbesserten Verschleißverhalten aufweist, wobei der eingelagerte Faservorkörper mit seiner zur Arbeitsfläche hinweisenden Körperseite geringere Porositätswerte aufweist als zu der der Arbeitsfläche abgewandten Seite des Verbundwerkstoffes.

2. Aluminiummatrix-Verbundwerkstoff nach Anspruch 1,
dadurch gekennzeichnet,
daß die Fasern des Faserformkörpers an den Kreuzungspunkten durch Sintern verbunden sind.

3. Aluminiummatrix-Verbundwerkstoff nach einem der vorhergehenden Ansprüche,
dadurch gekennzeichnet,
daß die Arbeitsfläche von der Vorkörperstruktur des Verbundwerkstoffs gebildet wird.

4. Aluminiummatrix-Verbundwerkstoff nach einem der vorhergehenden Ansprüche,
dadurch gekennzeichnet,
daß die Vorkörperstruktur über den Querschnitt gesehen einen Gradientenaufbau aufweist, wobei die Porositätswerte zwischen 20 und 98 % liegen.

5. Aluminiummatrix-Verbundwerkstoff nach einem der vorhergehenden Ansprüche,
dadurch gekennzeichnet,
daß im Vorkörper homogene Bereiche mit 20 und 98 % Porosität vorliegen.

6. Aluminiummatrix-Verbundwerkstoff nach einem der vorhergehenden Ansprüche,
dadurch gekennzeichnet,
daß der Vorkörper einen Schichtaufbau aufweist, mit einer Stützschicht aus einer grobporigen und einer Außenschicht aus einer feinporigen Vorkörperstruktur, die an den Kreuzungspunkten zusammengesintert sind.

7. Aluminiummatrix-Verbundwerkstoff nach einem der vorhergehenden Ansprüche,
dadurch gekennzeichnet,
daß die Schichten aus Fasern mit unterschiedlicher chemischer und physikalischer Beschaffenheit bestehen.

8. Aluminiummatrix-Verbundwerkstoff nach einem der vorhergehenden Ansprüche,
dadurch gekennzeichnet,
daß eine Aluminium-Nickel-Legierung mit Aluminiumgehalten von 7 bis zu 40 % für die Herstellung von schmelzextrahierten Fasern verwendet wird.

9. Aluminiummatrix-Verbundwerkstoff nach einem der vorhergehenden Ansprüche,
dadurch gekennzeichnet,
daß für die Herstellung der Fasern eine Eisen-Nickel-Aluminium-Legierung verwendet wird.

10. Verfahren zur Herstellung eines Aluminiummatrix-Verbundwerkstoffs nach einem der vorhergehenden Ansprüche, bestehend aus einem porösen Faservorkörper, der mit einer Aluminiumlegierung infiltriert wurde, wobei
13.1 die durch ein Schmelzextraktionsverfahren gewonnenen Fasern des Faservorkörpers, zu einer Gradientenstruktur aufbereitet und durch Sinterung zu einem festen, porösen Vorkörper verbunden werden,
13.2 der Faservorkörper als Faserformkörper mit gezielter Faserorientierung der metallischen Fasern und Versinterung der Kreuzungspunkte gebildet wird, wobei
13.3 der Faservorkörper eine offene Porosität von 20 bis 98 % aufweist, die über die Fasergeometrie und die Faserorientierung bei der Schichtung steuerbar ist,
13.4 der Faservorkörper auf eine Temperatur > 200 °C vorgeheizt wird und dann mit einer siliziumhaltigen, Aluminiumgußlegierungsschmelze infiltriert wird.

11. Verfahren nach Anspruch 10,
dadurch gekennzeichnet,
daß die Infiltration nach dem Schwerkraftguß-Verfahren durchgeführt wird.

12. Verfahren nach Anspruch 10,
dadurch gekennzeichnet,
daß die Infiltration im Druckgießverfahren bei einer Anschnittgeschwindigkeit von > 5 m/Sek. erfolgt.

13. Verfahren nach Anspruch 10,
dadurch gekennzeichnet,
daß der Faservorkörper in einer Druckgußform mit einer Druckgußlegierung bei einem Mindestdruck von 8 MPa (80 bar) infiltriert wird.

14. Verfahren nach einem der vorhergehenden Ansprüche,
dadurch gekennzeichnet,
daß die Porengrößen des Faservorkörpers durch den Fasergehalt pro Volumeneinheit des Vorkörpers im Bereich von 20 µm bis 1000 µm eingestellt werden.

15. Verfahren nach einem der Ansprüche 10, 12 bis 13,
dadurch gekennzeichnet,
daß die Infiltration in einem druckunterstützten Gießverfahren erfolgt, wobei der Druck solange aufrechterhalten wird, bis sich eine Diffusionszone zwischen dem Faserwerkstoff und der Matrix ausgebildet hat.

16. Verfahren nach einem der vorhergehenden Ansprüche,
dadurch gekennzeichnet,
daß gleichzeitig mit oder nach der Infiltration mit Aluminiumschmelze der Faservorkörper umgossen wird mit einem Matrixwerkstoff, ausgewählt aus einem oder mehreren Metallen der folgenden Gruppe:
Aluminium-Silicium-Magnesium-Zink (Gußwerkstoffe) in Kombination mit den Intermetallics Eisen-, Nickel-, Titan-Aluminide Wolfram, Kupfer, Kobalt und/oder Magnesium.

## Claims

1. A composite material with an aluminium matrix, consisting of a porous preformed fibre member which is embedded in an aluminium alloy, whose strength is higher than that of the aluminium matrix and which comprises an improved wear behaviour, wherein
1.1 the fibre member consists of an iron chromium aluminium alloy which is insensitive to oxidation, with Fe = 50 - 85 % by weight, Cr = 10 - 30 % by weight, Al = 5 - 20 % by weight or of aluminium nickel alloys with aluminium contents of 7 - 40 % or of iron nickel aluminium alloys or of intermetallic aluminides of type AlFe, AlTi, AlNi;
1.2 the fibres of the preformed fibre member obtained by a melt-extraction process consist of individual fibres of length L = 0.5 - 5 mm with a fibre diameter of 1 to 50 µm;
1.3 a silicon-containing aluminium casting alloy melt is infiltrated into the preformed fibre member, with the silicon content of the melt amounting to 5 - 14 % per weight;
1.4 the composite material comprises at least one working surface with an improved wear behaviour, with the incorporated preformed fibre member, at its member end facing the working surface, comprising lower porosity values than towards the end of the composite material facing away from the working surface.

2. A composite material with an aluminium matrix, according to claim 1,
characterised in
that the fibres of the formed fibre member are connected by sintering at the points of intersection.

3. A composite material with an aluminium matrix, according to any one of the preceding claims,
characterised in
that the working surface is formed by the preformed member structure of the composite material.

4. A composite material with an aluminium matrix, according to any one of the preceding claims,
characterised in
that, if viewed across its cross-section, the preformed member structure comprises a gradient, with the porosity values ranging between 20 and 98 %.

5. A composite material with an aluminium matrix, according to any one of the preceding claims,
characterised in
that in the preformed member there are contained homogeneous regions with a porosity of 20 to 98 %.

6. A composite material with an aluminium matrix, according to any one of the preceding claims,
characterised in
that the preformed member comprises a layered construction with a supporting layer consisting of a coarse-pourous preformed member structure and with an outer layer consisting of a fine-porous preformed member structure, with the supporting layer and outer layer being sintered together at the points of intersection.

7. A composite material with an aluminium matrix, according to any one of the preceding claims,
characterised in
that the layers consist of fibres with different chemical and physical conditions.

8. A composite material with an aluminium matrix, according to any one of the preceding claims,
characterised in
that an aluminium nickel alloy with aluminium contents of 7 to 40 % is used for producing melt-extracted fibres.

9. A composite material with an aluminium matrix,
characterised in
that an iron nickel aluminium alloy is used for producing the fibres.

10. A process of producing a composite material with an aluminum matrix, according to any one of the preceding claims, consisting of a porous preformed fibre member into which there is infiltrated an aluminium alloy, wherein
10.1 the fibres of the preformed fibre member obtained by a melt-extraction process are processed for the purpose of being given a gradient structure and are connected by sintering to form a firm, porous preformed member;
10.2 the preformed fibre member is formed into a formed fibre member with a specific fibre orientation of the metallic fibres, with the fibres being sintered at the points of intersection;
10.3 the preformed fibre member comprises an open porosity of 20 - 98 % which is controllable via the fibre geometry and the fibre orientation during layering.
10.4 the preformed fibre member is heated to a temperature of > 200 °C, with a silicon-containing aluminium casting alloy melt being infiltrated into the preformed fibre member.

11. A method according to claim 10,
characterised in
that infiltration takes place in accordance with the gravity die casting method.

12. A process according to claim 10,
characterised in
that infiltration takes place in accordance with the high-pressure die casting process at an ingate speed of > 5 m/sec.

13. A process according to claim 10,
characterised in
that in a high-pressure die, a high-pressure die-cast alloy is infiltrated into the preformed fibre member at a mimimum pressure of 8 Mpa (80 bar).

14. A process according to any one of the preceding claims,
characterised in
that the pore sizes of the preformed fibre member are set by the fibre content per volume unit of the preformed member in the range of 20 µm to 1000 µm.

15. A process according to any one of claims 10, 12 to 13,
characterised in
that infiltration takes place in accordance with a pressure-assisted casting method, with the pressure being maintained until there has been formed a diffusion zone between the fibre material and the matrix.

16. A process according to any one of the preceding claims,
characterised in
that, simultaneously with or after the infiltraton of the aluminium melt, a matrix material is cast around the preformed fibre member, which matrix material is selected from one or several metals of the following group:
aluminium-silicon-magnesium-zinc (casting materials) combined with the intermetallics;
iron-, nickel-, titanium-aluminides;
tungsten, copper, colbalt and/or magnesium.

## Revendications

1. Matériau composite à matrice en aluminium, constitué par un corps précurseur poreux en fibres noyé dans un alliage d'aluminium et présentant une solidité supérieure à celle de la matrice en aluminium et un comportement amélioré vis-à-vis de l'usure, dans lequel
1.1 le corps en fibres est constitué par des fibres d'un alliage fer/chrome/aluminium insensible à l'oxydation avec Fe = 50 - 85 % en poids, Cr = 10 - 30 % en poids, Al = 5 - 20 % en poids, ou par des alliages aluminium/nickel avec des teneurs d'aluminium de 7 - 40 % ou bien par des alliages fer/nickel/aluminium ou encore par des aluminides intermétalliques du type AlFe, AlTi, AlNi ;
1.2 les fibres du corps précurseur en fibres obtenues par un procédé d'extraction par fusion sont constituées par des fils individuels d'une longueur L = 0,5 à 5 mm avec un diamètre de fibres de 1 à 50 µm ;
1.3 le corps précurseur en fibres est infiltré avec une fonte d'alliage d'aluminium siliceux, la teneur en Si de la fonte étant de 5 à 14 % en poids ;
1.4 le matériau composite comprend au moins une surface de travail présentant un comportement amélioré vis-à-vis de l'usure, le corps précurseur noyé présentant, sur son côté tourné vers la surface de travail, des valeurs de porosité plus faibles que sur le côté détourné de la surface de travail du matériau composite.

2. Matériau composite à matrice en aluminium selon la revendication 1, caractérisé en ce que les fibres du corps conformé en fibres sont reliées par frittage aux points de croisement.

3. Matériau composite à matrice en aluminium selon l'une ou l'autre des revendications précédentes, caractérisé en ce que la surface de travail est formée par la structure du corps précurseur du matériau composite.

4. Matériau composite à matrice en aluminium selon l'une quelconque des revendications précédentes, caractérisé en ce que, vue sur sa section, la structure du corps précurseur présente une structure à gradients, les valeurs de la porosité étant comprises entre 20 et 98 %.

5. Matériau composite à matrice en aluminium selon l'une quelconque des revendications précédentes, caractérisé en ce que dans le corps précurseur il existe des zones homogènes avec des porosités de 20 et de 98 %.

6. Matériau composite à matrice en aluminium selon l'une quelconque des revendications précédentes, caractérisé en ce que le corps précurseur comprend une structure de couches qui comporte une couche de soutien constituée par une structure de corps précurseur à pores grossiers et une couche extérieure constituée par une structure de corps précurseur à pores fins, qui sont frittées ensemble au niveau des points de croisement.

7. Matériau composite à matrice en aluminium selon l'une quelconque des revendications précédentes, caractérisé en ce que les couches sont constituées par des fibres présentant différentes propriétés chimiques et physiques.

8. Matériau composite à matrice en aluminium selon l'une quelconque des revendications précédentes, caractérisé en ce qu'un alliage aluminium/nickel avec des teneurs d'aluminium de 7 à 40 % est utilisé pour produire les fibres extraites par fusion.

9. Matériau composite à matrice en aluminium selon l'une quelconque des revendications précédentes, caractérisé en ce que pour produire les fibres, on utilise un alliage fer/nickel/aluminium.

10. Procédé pour réaliser un matériau composite à matrice en aluminium selon l'une quelconque des revendications précédentes, constitué par un corps précurseur poreux en fibres infiltré avec un alliage d'aluminium, dans lequel
10.1 les fibres du corps précurseur en fibres obtenues par un procédé d'extraction par fusion sont traitées pour former une structure à gradients et reliées par frittage pour former un corps précurseur poreux solide ;
10.2 le corps précurseur en fibres est formé comme un corps conformé en fibres avec orientation ciblée des fibres métalliques et avec frittage des points de croisement ;
10.3 le corps précurseur en fibres présente une porosité ouverte de 20 à 98 % susceptible d'être commandée via la géométrie des fibres et via l'orientation des fibres lors de la constitution des couches ; et
10.4 le corps précurseur de fibres est préchauffé à une température > 200°C et il est ensuite infiltré avec une fonte d'alliage d'aluminium siliceux.

11. Procédé selon la revendication 10, caractérisé en ce que l'on effectue l'infiltration selon le procédé de coulée par gravité.

12. Procédé selon la revendication 10, caractérisé en ce que l'infiltration dans le procédé de coulée sous pression s'effectue à une vitesse d'attaque > 5 m/sec.

13. Procédé selon la revendication 10, caractérisé en ce que le corps précurseur en fibres est infiltré dans un moule de coulée sous pression avec un alliage de coulée sous pression à une pression minimum de 8 Mpa (80 bar).

14. Procédé selon l'une quelconque des revendications précédentes, caractérisé en ce que les tailles des pores du corps précurseur de fibres sont réglées dans la plage de 20 µm à 1000 µm par la teneur en fibres par unité volumique du corps précurseur.

15. Procédé selon l'une quelconque des revendications 10, 12 et 13, caractérisé en ce que l'infiltration est effectuée dans un procédé de coulée assisté par pression, la pression étant maintenue aussi longtemps qu'une zone de diffusion se forme entre le matériau de fibres et la matrice.

16. Procédé selon l'une quelconque des revendications précédentes, caractérisé en ce que simultanément ou après l'infiltration avec la fonte d'aluminium, le corps précurseur de fibres est entouré par coulée avec un matériau de matrice choisi parmi un ou plusieurs métaux des groupes comprenant :
aluminium-silicium-magnésium-zinc (matériaux de coulée) en combinaison avec les intermétalliques
aluminides de fer, de nickel, de titane,
tungstène, cuivre, cobalt et/ou magnésium.
